# FASCICULE DE BREVET EUROPEEN

(11) **EP 2 556 180 B1**
(45) Date de publication et mention de la délivrance du brevet: **11.06.2014**
(21) Numéro de dépôt: 11714251.3
(22) Date de dépôt: 05.04.2011
(51) Int. Cl.: C23C 16/27, C23C 16/02

(54) **PROCEDE DE FABRICATION D'UN MATERIAU POREUX EN DIAMANT DE SYNTHESE**
VERFAHREN ZUR HERSTELLUNG EINES PORÖSEN SYNTHETISCHEN DIAMANTSTOFFES
METHOD FOR MANUFACTURING A POROUS SYNTHETIC DIAMOND MATERIAL

(30) Priorité: 07.04.2010 FR 1052613
(43) Date de publication de la demande: 13.02.2013
(73) Titulaire: Commissariat à l'Énergie Atomique et aux Énergies Alternatives, 75015 Paris (FR)
(72) Inventeur: SCORSONE, Emmanuel, F-78114 Magny-Les-Hameaux (FR); GIRARD, Hugues, F-78220 Viroflay (FR)
(74) Mandataire: Ilgart, Jean-Christophe
(86) Numéro de dépôt international: PCT/EP2011/055263
(87) Numéro de publication internationale: WO 2011/124568

(56) Documents cités:
- US-B1- 6 749 931
- BARANAUSKAS V ET AL: "Method of porous diamond deposition on porous silicon", APPLIED SURFACE SCIENCE ELSEVIER NETHERLANDS, vol. 185, no. 1-2, 28 décembre 2001 (2001-12-28), pages 108-113, XP002611519, ISSN: 0169-4332 cité dans la demande

## Description

### DOMAINE TECHNIQUE

L'invention concerne un procédé permettant de fabriquer un matériau poreux en diamant de synthèse, de préférence constitué uniquement de diamant de synthèse.

### ÉTAT DE LA TECHNIQUE ANTÉRIEURE

Le diamant est un matériau particulièrement intéressant car il possède des propriétés mécaniques, électriques, thermiques et optiques exceptionnelles et à caractère unique par rapport aux autres matériaux connus.

Il peut être utilisé dans de nombreux domaines ; il peut par exemple être utilisé en microélectronique pour la réalisation de microsystèmes et de circuits intégrés, car c'est un excellent matériau diélectrique, ou encore en chimie pour la fabrication d'électrodes utilisées pour la détection chimique.

D'autre part, le diamant est aussi un matériau qui est chimiquement et biologiquement inerte et il fait donc l'objet de nombreuses recherches scientifiques dans le domaine médical et plus particulièrement dans le domaine des implants et de l'interrogation neuronale.

Enfin, c'est un matériau possédant des propriétés électrochimiques excellentes. En effet, le diamant, qui est un isolant électrique lorsqu'il est intrinsèque, devient conducteur lorsqu'il est dopé avec des impuretés. Ainsi, il est possible de réaliser des électrodes en diamant dopé qui possèdent une grande fenêtre de potentiel (environ 3 volts), une grande résistance à la corrosion et une résistance mécanique importante comparées aux autres matériaux habituellement utilisés en électrochimie, ainsi qu'un faible courant de fond.

La croissance du diamant synthétique est généralement réalisée dans un réacteur de croissance CVD (de l'anglais Chemical Vapour Deposition) par dépôt chimique à partir d'une phase vapeur assistée par plasma (le plasma pouvant être créé en utilisant une source d'énergie telle que des micro-ondes (dépôt MPCVD), des Radio-Fréquences (dépôt RFCVD) ou un filament chaud (dépôt HFCVD)). La phase vapeur comprend de l'hydrogène et une source de carbone, par exemple du méthane, et le dépôt est réalisé sur un substrat qui est préalablement préparé pour initier la croissance du diamant.

La préparation du substrat peut consister à déposer des grains de diamant de taille nanométrique sur la surface du substrat, qui vont croître lors de l'étape de croissance CVD jusqu'à l'obtention d'un film continu de diamant.

Une autre méthode de préparation du substrat consiste à rayer la surface du substrat afin que les défauts ainsi engendrés sur la surface constituent des sources de nucléation permettant la formation de grains de diamant de taille nanométrique qui vont croître jusqu'à l'obtention d'un film continu de diamant.

Les films de diamant ainsi obtenus ont généralement une forme polycristalline colonnaire ou nanocristalline en fonction des conditions de croissance. Les films de diamant obtenus sont donc très compacts et possèdent une porosité nulle ou quasi nulle. Ainsi, les surfaces en diamant disponibles sont limitées à la face supérieure presque plane du substrat ou à la fois à la face supérieure et à la face inférieure du substrat après séparation du film de diamant de son substrat support dans les cas particuliers où le film de diamant est suffisamment épais pour être auto-supporté.

Pour de nombreuses applications, il est cependant nécessaire d'avoir une très grande surface disponible en diamant. C'est par exemple le cas en électrochimie où la réactivité de l'électrode dépend de sa surface active.

Une manière d'augmenter la surface active du diamant consiste à graver la couche de diamant en surface de façon à augmenter sa rugosité de surface. Cette méthode est par exemple utilisée pour fabriquer des biocapteurs en greffant des brins d'ADN sur des nanofils de diamant (voir le document **[1]** référencé à la fin de cette description). On obtient ainsi un film de diamant ayant une porosité en deux dimensions (c'est-à-dire uniquement une porosité de surface).

Une autre méthode connue permet d'obtenir des couches à base de diamant ayant une surface très rugueuse et présentant une porosité en 3 dimensions. Cette méthode consiste à faire croitre le diamant en procédant à un dépôt CVD classique sur un support qui présente déjà la géométrie tridimensionnelle que l'on souhaite donner au diamant (voir par exemple le document **[2],** où le support est du silicium poreux, et le document **[3],** où le support est une mousse de carbure de silicium). On obtient alors un matériau dit « hybride » ou « composite » puisqu'il est composé à la fois de diamant et du matériau du support.

Cette méthode présente l'avantage que le diamant composite ou hybride est facilement réalisable. Cependant, certaines des propriétés de ces matériaux composites sont dégradées par rapport aux matériaux en diamant massif, comme par exemple leur résistance mécanique.

Une autre méthode de réalisation d'un matériau diamant en 3 dimensions consiste à utiliser des fibres de verre comme support pour la croissance du diamant (voir le document **[4]).** Après la croissance du diamant, les fibres sont gravées dans une solution à base d'acide fluoridrique et l'on obtient une structure poreuse tridimensionnelle en diamant sous forme d'un enchevêtrement de tubes en diamant.

Cependant, cette technique repose sur la manipulation de filtres à base de fibres de verre faisant office de support pendant la croissance du diamant. Or, après la gravure du support en fibres de verre, on obtient un film auto-supporté qui est très fragile et qui nécessite d'être consolidé en étant adhéré sur un support. L'inconvénient est que cette étape de report est particulièrement difficile à réaliser par l'homme du métier.

D'autre part, l'utilisation d'un tel matériau pour fabriquer des petits objets, par exemple des objets de taille micrométrique, est exclue de part la difficulté à le manipuler. Par exemple, la réalisation de microélectrodes, qui nécessite le dépôt et la prise de contact du diamant poreux sur un support métallique de taille micrométrique, est compromise.

D'autres méthodes permettant d'obtenir un diamant poreux ont été décrites dans la littérature.

Par exemple, une de ces méthodes consiste à déposer des grains de diamant de taille nanométrique sur un support, puis de lier les grains entre eux en utilisant de l'hexachlorodisiloxane pour former des liaisons chimiques fortes entre les grains adjacents (voir le document **[5]).**

Un inconvénient majeur de cet amas de grains est que la terminaison de surface du diamant ne peut pas être modifiée, car les grains seraient alors désolidarisés les uns des autres lors de la modification de surface.

Or, il est intéressant de pouvoir modifier la surface du diamant, par exemple en l'oxydant pour améliorer sa mouillabilité, ou en greffant des molécules actives électrochimiquement pour faire de la détection chimique ou biochimique.

De plus, bien que les grains soient attachés les uns aux autres par des liaisons fortes, ces dernières sont moins fortes que les liaisons sp3 du diamant. Cet ensemble formé d'un amas de grains sera donc moins robuste qu'un matériau diamant constitué majoritairement de liaisons carbone sp3.

Une autre méthode consiste à introduire une proportion de carbone en état d'hybridation sp2 dans une couche de diamant non poreuse, par exemple par implantation d'ions, puis à graver les carbones sp2 dans un plasma d'hydrogène (voir le document **[6]).**

Cependant, comme l'implantation ne se fait qu'en surface de la couche de diamant, il est nécessaire de procéder à plusieurs cycles successifs d'implantation/gravure jusqu'à obtenir l'épaisseur de film poreux en diamant souhaité. Cette méthode est donc relativement longue.

Le diamant poreux peut également être fabriqué en chauffant à très haute température (1150 °C) et à haute pression (5 Gpa) une masse de grains de diamant disposée sur un substrat (voir le document **[7]).** Dans ce cas, la taille des pores et la porosité de la couche en diamant peuvent être modifiées en mélangeant un diluant à la masse de grains de diamant avant de procéder au chauffage. Cette méthode ne peut cependant être appliquée que lorsque le substrat peut supporter les conditions opératoires (température et pression).

Enfin, il est possible de faire croitre une masse de grains de diamant par dépôt CVD en utilisant la méthode dite de photo-fragmentation du fullerène en phase vapeur (voir le document **[8]).** Pour cela, des vapeurs de fullerène sont introduites dans le réacteur de croissance CVD et diffusent dans les pores de la masse de grains de diamant. Lorsque les molécules de fullerène sont fortement illuminées par un faisceau laser, elles se décomposent et constituent une source de carbone permettant la croissance du diamant dans les pores et une fixation des grains entre eux. Cette méthode, encore une fois, ne peut s'appliquer que si le substrat peut supporter les conditions opératoires.

L'inventeur s'est donc fixé comme but de remédier au moins partiellement aux problèmes mentionnés ci-dessus relatifs aux modes de réalisation de l'art antérieur en concevant un procédé de fabrication d'un matériau en diamant qui soit entièrement poreux, qui soit facilement réalisable et qui soit, de préférence, uniquement constitué en diamant.

### EXPOSÉ DE L'INVENTION

Ce but est atteint grâce à un procédé de fabrication d'une couche en diamant ayant une structure tridimensionnelle poreuse, le procédé étant du type comprenant la croissance de la couche en diamant à partir d'un matériau sacrificiel et la décomposition progressive de ce matériau sacrificiel au cours de la croissance de la couche en diamant, ledit procédé comprenant les étapes suivantes :
1) la fourniture d'un substrat apte à supporter la croissance par dépôt chimique en phase vapeur (CVD) assisté par plasma de la couche de diamant sur au moins une des faces du substrat, le substrat comportant sur ladite au moins une face une couche en un matériau sacrificiel ayant une structure tridimensionnelle poreuse et étant apte à se décomposer progressivement au contact de ce plasma, la couche en matériau sacrificiel contenant des grains de diamant de taille nanométrique ;
2) la croissance par dépôt chimique en phase vapeur assisté par plasma de la couche en diamant à partir des grains de diamant et la décomposition concomitante et progressive du matériau sacrificiel au contact de ce plasma.

On précise que lorsque l'on dit que la décomposition est « concomitante », cela signifie que la décomposition et la croissance s'effectuent en même temps, mais ne signifie pas qu'elles débutent et se terminent nécessairement aux mêmes instants.

Dans ce qui précède et ce qui suit, le terme « taille », appliqué à des grains ou à des pores, désigne la plus grande dimension de ces grains ou de ces pores, et le terme « nanométrique » signifie supérieur ou égal à 1 nanomètre et inférieur à 1000 nanomètres.

On rappelle par ailleurs que le terme « grains » désigne des particules dont le rapport de la plus grande dimension sur la plus petite dimension est inférieur ou égal à 5. Les grains peuvent donc être sphériques ou quasi-sphériques, cubiques ou quasi-cubiques, rhomboédrique ou quasi-rhomboédrique...

Dans ce qui suit, on pourra utiliser le terme « nano-poudre de diamant » à la place de l'expression « poudre de diamant dont les grains sont de taille nanométrique », étant entendu que la « nano-poudre » désigne un ensemble de grains dont la plus grande dimension est supérieure ou égale à 1 nanomètre et inférieure à 1000 nanomètres.

De préférence, la croissance de la couche en diamant est stoppée lorsqu'à la fois la décomposition du matériau sacrificiel est complète (le matériau sacrificiel a complètement disparu) et que la couche en matériau diamant a une porosité souhaitée.

Avantageusement, la décomposition du matériau sacrificiel comporte la gravure du matériau sacrificiel par le plasma.

Selon le procédé de l'invention, de la poudre de diamant dont les grains sont de taille nanométrique est incorporée dans un matériau sacrificiel possédant une structure tridimensionnelle poreuse et l'ensemble formé par le matériau sacrificiel comprenant les grains de diamant est supporté par un substrat. Le matériau sacrificiel est choisi de manière à ce qu'il présente la propriété de se décomposer lentement (de préférence par gravure) dans le plasma de croissance du diamant. De préférence, la croissance du diamant est prolongée (impliquant donc la présence du plasma) jusqu'à la disparition complète du matériau sacrificiel en fin de croissance CVD du diamant. Ainsi, pendant la croissance du diamant, le matériau sacrificiel disparait progressivement, laissant apparaitre sur le substrat une couche de diamant ayant une structure poreuse tridimensionnelle.

Il est à noter que lorsque l'on dit que le matériau sacrificiel et le diamant ont une structure tridimensionnelle poreuse, cela signifie que la porosité elle-même est tridimensionnelle et se situe dans l'ensemble du volume du matériau et non seulement en surface. Dans la suite de la description, on considérera que le matériau sacrificiel et le diamant sont poreux, en gardant en mémoire que la porosité est une porosité tridimensionnelle, c'est-à-dire qu'elle n'est pas située seulement en surface du matériau, mais qu'elle s'étend dans les trois dimensions du matériau (hauteur, largeur, épaisseur) c'est-à-dire dans son volume. En outre, comme l'homme du métier l'aura compris, il s'agit d'une porosité ouverte, c'est-à-dire que chaque pore communique avec les autres pores, car les pores sont interconnectés : n'importe quel pore situé à l'intérieur du matériau est accessible de l'extérieur du matériau. En fait, le matériau a une porosité ouverte sur la totalité de son épaisseur et est perméable.

Le procédé de fabrication selon l'invention permet donc d'obtenir un matériau poreux qui est constitué uniquement de diamant (dans le cas où la croissance du diamant est prolongée jusqu'à la disparition complète du matériau sacrificiel) et qui peut être fabriqué sur tout substrat capable de supporter la croissance CVD du diamant telle qu'elle est connue de l'homme du métier. Le matériau sacrificiel et le diamant obtenu par le procédé de fabrication selon l'invention ont tous deux une structure tridimensionnelle poreuse ; la couche de diamant obtenue est poreuse et sa porosité dépend à la fois de la porosité de la couche de matériau sacrificiel et du temps de croissance du diamant.

On précise qu'il existe plusieurs méthodes pour synthétiser du diamant par croissance CVD, connues de l'homme du métier, parmi lesquelles les méthodes de dépôt de vapeur chimique assisté par plasma micro-onde (PACVD) ou radio-fréquence (RF) ou par filament chaud sont les plus utilisées. La méthode PACVD, par exemple, consiste généralement à faire croitre des grains de diamant de taille nanométrique sur un substrat placé dans un réacteur de croissance PACVD, fonctionnant typiquement à 800-1500 watts, et dans un mélange gazeux comprenant au moins un mélange de méthane (source de carbone) et de dihydrogène dans une proportion adéquate. Pendant la croissance du diamant par la méthode PACVD, la température du substrat est généralement comprise entre 400 et 900°C.

Le matériau dans lequel est immobilisé la nano-poudre de diamant est dit sacrificiel, c'est-à-dire qu'il va se décomposer progressivement durant la phase de croissance CVD assistée par plasma du diamant. De préférence, ce matériau est choisi pour avoir la propriété de se décomposer lentement dans le plasma de croissance du diamant jusqu'à sa disparition complète en fin de croissance.

Avantageusement, le matériau sacrificiel est un polymère. De préférence, le matériau sacrificiel est un polypyrrole. Par polypyrrole, on entend tous les polymères issus du pyrrole, c'est-à-dire les homopolymères comportant des unités de pyrrole. Le matériau sacrificiel peut aussi être le poly(N-méthyl pyrrole) ou tous les homopolymères comportant des unités de N-méthyl pyrrole.

Selon une variante, lorsque le matériau sacrificiel est un polymère, le substrat et le matériau sacrificiel peuvent être électriquement conducteurs et la couche en matériau sacrificiel présente sur au moins une face du substrat peut être déposée par électro-polymérisation.

Le matériau sacrificiel, lorsque c'est un polymère, peut également être fabriqué en procédant à la polymérisation chimique du polymère en présence d'un agent oxydant. Dans le cas où le polymère est du polypyrrole, l'agent oxydant peut être le chlorure de fer.

Avantageusement, la taille des grains de diamant est inférieure ou égale à 100 nm, de préférence inférieure ou égale à 15 nm.

De préférence, la nano-poudre de diamant est préférentiellement de la poudre de détonation, du fait de la petitesse de la taille de ses grains (5 à 15 nanomètres pour la nano-poudre primaire). Alternativement la nano-poudre peut être aussi obtenue par broyage de poudre de diamant de taille plus grossière. Le diamètre d'intérêt de la nano-poudre de diamant sera typiquement de l'ordre de 1 à 100 nm. Dans les deux cas, le coeur de la nano-poudre est composé en grande majorité de carbone hybride sp3. La nano-poudre de diamant pourra être utilisée brute, ou après purification dans le cas de la poudre de détonation.

Avantageusement, la couche de diamant poreux a une porosité occupant de 5 à 50% du volume totale de la couche de diamant poreux.

Avantageusement, les pores de la couche en matériau sacrificiel ont une taille au moins 2 fois plus grande que la taille des grains de diamant qui doivent être incorporés dans le matériau sacrificiel. Les pores de la couche en matériau sacrificiel peuvent ainsi avoir une taille pouvant atteindre plusieurs micromètres.

Le diamant poreux obtenu selon le procédé de l'invention présente de nombreux avantages.

Tout d'abord, contrairement à certains des matériaux décrits dans l'art antérieur, le matériau obtenu peut être composé uniquement de diamant si la croissance du diamant est poursuivie jusqu'à la disparition complète du matériau sacrificiel. En d'autres termes, ce n'est pas un matériau composite. Ainsi, toutes les propriétés intrinsèques du diamant peuvent être conservées.

Ensuite, contrairement aux matériaux généralement développés pour leurs propriétés diélectriques et possédant une taille de pores très petite (classiquement comprises entre 1 et 100 nm), la porosité du matériau obtenu selon le procédé de l'invention peut être très large, avec des tailles de pores pouvant atteindre plusieurs micromètres, ce qui permet par exemple d'y intercaler des cellules biologiques.

Enfin, contrairement à certains matériaux obtenus par des techniques de recuit à très hautes températures ou à l'aide d'une illumination laser, ce matériau diamant peut être mis à croitre dans des conditions expérimentales courantes dans un réacteur de croissance du diamant par la méthode CVD. Il peut ainsi être fabriqué sur tout type de substrat pouvant résister à une croissance de diamant CVD, qui est une méthode de croissance à basse température (c'est-à-dire inférieure ou égale à 1000°C) et à basse pression (c'est-à-dire inférieure ou égale à 300 mbar) dans un réacteur de croissance. Il peut ainsi, par exemple, être réalisé sur des substrats de verre qui ne supportent pas des températures supérieures à 800°C.

De plus, dans le cas où le matériau sacrificiel est du polypyrrole, l'utilisation du polypyrrole présente l'avantage de pouvoir être déposé à température ambiante sur tout type de substrat compatible avec la croissance du diamant par une méthode de dépôt CVD. En outre, le polypyrrole peut être déposé par électro-polymérisation sur la plupart des substrats électriquement conducteurs qui sont classiquement utilisés pour la croissance du diamant de synthèse. Il est ainsi possible de déposer le polypyrrole localement uniquement sur des structures électriquement conductrices d'un substrat, de doper le polypyrrole avec de la nano-poudre de diamant (mais la nano-poudre peut également être déjà présente dans le polypyrrole avant qu'il ne soit déposé sur le substrat), pour ensuite faire croitre une couche de diamant poreux uniquement sur les structures conductrices. Cette méthode de structuration de la couche poreuse en diamant est particulièrement avantageuse pour la fabrication de microélectrodes en diamant.

### BRÈVE DESCRIPTION DES DESSINS

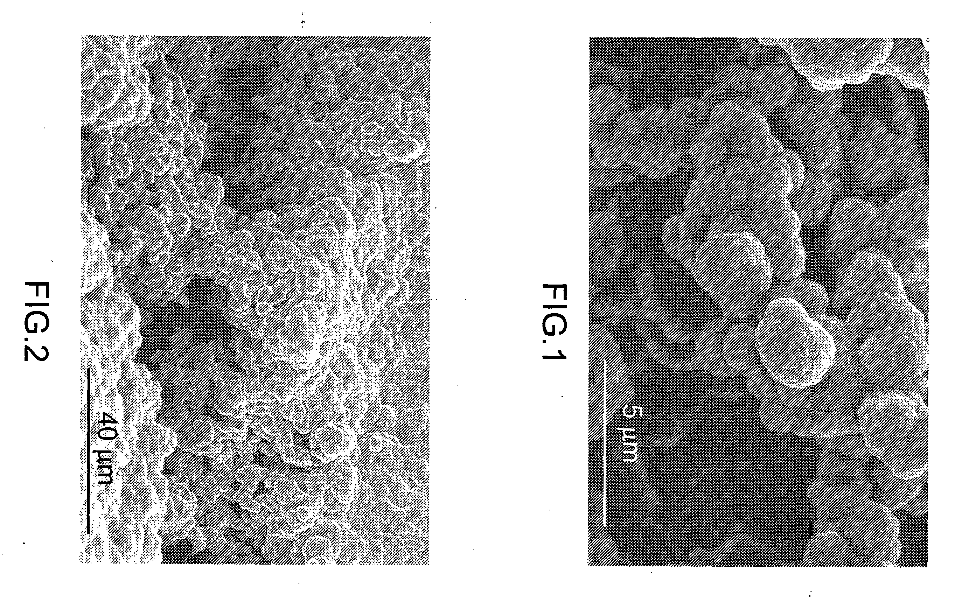

L'invention sera mieux comprise et d'autres avantages et particularités apparaîtront à la lecture de la description qui va suivre, donnée à titre d'exemple non limitatif, accompagnée des figures annexées parmi lesquelles la figure 1 et la figure 2 sont deux photographies prises à l'aide d'un microscope à balayage électronique d'un même matériau en diamant poreux obtenu selon le procédé de l'invention, montrées selon deux échelles différentes.

### EXPOSÉ DÉTAILLÉ DE MODES DE RÉALISATION PARTICULIERS

Nous avons vu ci-dessus que le matériau sacrificiel utilisé dans le procédé selon l'invention peut être un polymère et est de préférence un polypyrrole.

Le polypyrrole peut être fabriqué soit par oxydation chimique (polymérisation chimique sous l'action d'oxydants), soit par électro-polymérisation.

Dans le cas d'une polymérisation chimique sous l'action d'oxydants, le polypyrrole est obtenu en mélangeant une solution contenant une quantité adéquate de pyrrole à une solution de concentration adéquate d'un' oxydant, par exemple du chlorure de fer (FeCl₃), ce qui provoque la polymérisation du polypyrrole, qui précipite alors dans le mélange puisqu'il est insoluble dans la plupart des solvants.

Les solvants utilisés pour dissoudre le pyrrole et le chlorure de fer sont soit de l'eau pure, soit un solvant organique, par exemple le méthanol, l'éthanol, ou l'acétonitrile. En fait, le choix des solvants est déterminé par la structure que l'on souhaite obtenir pour le polypyrrole. En effet, il est connu de l'homme du métier qu'en fonction des solvants utilisés, le polymère ainsi fabriqué aura une structure différente, par exemple une structure filaire de diamètre micrométrique à nanométrique, en forme de dendrites... Il est également possible d'ajouter directement le pyrrole dans une solution de chlorure de fer ou inversement, même si cela n'est pas la méthode préférée.

La nano-poudre de diamant est incorporée dans le polypyrrole pendant ou après la fabrication de ce dernier.

Dans le premier cas, de la nano-poudre de diamant est dispersée par ultrasonication intense dans la solution contenant le pyrrole ou dans la solution contenant l'oxydant (par exemple le chlorure de fer). Après le mélange des deux solutions, qui provoque la polymérisation, la nano-poudre de diamant est directement piégée dans la matrice polymère du polypyrrole.

Dans le second cas, le polypyrrole fabriqué comme indiqué ci-dessus est trempé dans une solution contenant une dispersion de nano-poudre de diamant dissoute dans un solvant adéquat, le plus souvent de l'eau ou de l'éthanol. De par sa taille nanométrique, une quantité suffisante de nano-poudre de diamant va être piégée en surface et dans les pores du polymère.

Pour obtenir du polypyrrole par polymérisation chimique, il est également possible de dissoudre un oxydant (par exemple du chlorure de fer) dans un solvant possédant un point d'ébullition et une viscosité élevés. Ce solvant sera par exemple du triéthylène glycol. Cette solution sera ensuite disposée sur un substrat, puis exposée à des vapeurs de pyrrole qui vont diffuser dans la solution contenant l'oxydant, puis polymériser sous l'action de ce dernier. Après rinçage du solvant ayant servi à immobiliser l'oxydant sur la surface du substrat, on obtient une couche de polypyrrole poreuse sur le substrat. Cette couche sera alors trempée, comme évoqué précédemment, dans une dispersion de nano-poudre de diamant afin d'immobiliser cette dernière dans la matrice polymère.

Dans le cas d'une électro-polymérisation, une solution d'électrolyte contenant du pyrrole et un sel de fond choisi parmi ceux généralement utilisés pour la réalisation de polymères, est utilisée dans un système classique à trois électrodes (électrode de travail, contre-électrode et électrode de référence) afin de déposer le polymère sur l'électrode de travail, en faisant circuler un courant entre l'électrode de travail et la contre-électrode. L'électrode de travail est en fait un substrat qui est électriquement conducteur et qui est choisi afin de pouvoir résister aux conditions de croissance du diamant par la méthode de dépôt CVD. Ce substrat peut par exemple être du silicium dopé.

La nano-poudre de diamant peut être incorporée au polymère pendant la phase d'électro-polymérisation en dispersant la nano-poudre de diamant dans la solution d'électrolyte par ultrasonication. Alternativement, la nano-poudre de diamant peut être immobilisée dans le polymère une fois réalisé en plongeant le film de polymère dans une dispersion de nano-poudre de diamant. Il est à noter que les conditions expérimentales d'électro-polymérisation du polymère seront choisies pour permettre la formation d'un film de polymère ayant une structure géométrique poreuse. Ceci sera possible en particulier grâce à un choix judicieux du sel de fond.

La couche de polypyrrole dopée à la nano-poudre de diamant, préparée selon l'une des méthodes décrites ci-dessus, est ensuite placée dans un réacteur de croissance CVD. Des conditions de croissances, bien connues de l'homme du métier, sont appliquées pour permettre la croissance des grains de diamant dans la matrice de polymère. Au fur et à mesure de la croissance, le polymère est gravé, pour obtenir en fin de procédé une couche composée uniquement de diamant. La couche de diamant obtenue est poreuse et présente une porosité qui dépend de la porosité de la couche de polymère sacrificielle et du temps de croissance du diamant.

Nous allons à présent décrire deux exemples de réalisation d'un support en diamant poreux selon l'invention, dans lequel le matériau sacrificiel est le polypyrrole.

### Exemple 1 :

Une solution de méthanol contenant 50 mg de pyrrole dans 10 mL de liquide est préparée.

En parallèle, on prépare 10 mL d'une solution aqueuse contenant 120 mg de chlorure de fer et dans laquelle une quantité de 0,1% en masse de poudre de diamant de taille nanométrique est dispersée par l'utilisation d'ultra-sons. On choisit la nano-poudre SYNDIA^{®} de Van Moppes, en Suisse, ayant la référence 11247 ; cette poudre possède les caractéristiques suivantes : 14,8 carats/kg et un « grade 0-0.02 GAF » en anglais, c'est-à-dire que la poudre de diamant est conditionnée sous forme de diamant liquide (elle est en solution et non sous forme sèche) et est garantie exempte d'agglomérats (GAF pour « guaranteed agglomerate free » en anglais), avec des particules de tailles comprises entre 0 et 0,02 µm.

Puis, on verse la solution de méthanol dans la solution aqueuse et on agite fortement la solution ainsi obtenue pendant environ 1 minute. Cette solution est ensuite conservée à une température de 4°C pendant 12 heures.

Un précipité noir de polypyrrole dopé à la nano-poudre de diamant est alors isolé de la solution, puis rincé abondamment dans de l'acétonitrile jusqu'à l'obtention d'une solution claire de rinçage, ne contenant pas de chlorure de fer.

Le précipité est alors déposé sur un substrat en silicium et ce substrat est ensuite introduit dans un réacteur de croissance CVD assisté par plasma micro-ondes. La croissance du diamant est réalisée dans les conditions suivantes :
- pression dans le réacteur : 40 mbar ;
- proportion des gaz : 99% de dihydrogène et 1% de méthane ;
- puissance des micro-ondes : 900 watt ;
- temps de croissance : 5 heures ;
- température du substrat : 800°C.

A la fin du dépôt, un film de diamant poreux est obtenu. Le film de diamant a une épaisseur de 30 micromètres et des pores dont la taille est comprise entre 0,5 et 10 micromètres.

Des photographies du film ainsi obtenu, prises à l'aide d'un microscope électronique à balayage, sont visibles dans les figures 1 et 2. En consultant ces deux figures, on constate que le matériau obtenu possède une structure dendritaire en trois dimensions très poreuse. La discontinuité du film observable dans la figure 2 provient de la discontinuité du film de polypyrrole avant la croissance du diamant.

### Exemple 2 :

Selon une variante de l'invention, du polypyrrole est fabriqué de la façon suivante.

Une solution de 4 moles par litre de chlorure de fer dissout dans du tri-éthylène glycol est déposé sur un substrat en silicium.

Le substrat est ensuite placé dans un dessiccateur dans lequel est également introduit un bécher contenant 5 mL de pyrrole. De l'azote est mis à circuler dans le dessiccateur selon un débit de 300 mL par minute et pendant une durée de 3 heures, qui correspond à la durée de la polymérisation.

Les vapeurs de pyrrole diffusent dans la solution oxydante de chlorure de fer et forment ainsi un précipité de polypyrrole dans la solution.

Le substrat est ensuite rincé abondamment dans de l'acétonitrile jusqu'à l'obtention d'une solution claire sans chlorure de fer.

Le substrat est ensuite séché à l'air, puis trempé pendant 5 minutes dans une solution d'éthanol contenant 1% en masse de poudre de diamant de taille nanométrique dispersé. Comme dans l'exemple 1, on choisit la nano-poudre SYNDIA^{®} de Van Moppes ayant la référence 11247, un « grade 0-0.02 GAF » et 14,8 carats/kg.

Le substrat est ensuite séché, puis introduit dans un réacteur de croissance CVD. La croissance est réalisée selon les conditions expérimentales décrites dans l'exemple 1.

On obtient un film de diamant poreux similaire à celui obtenu dans l'exemple 1.

### BIBLIOGRAPHIE

**[1]** C. E. Nebel and al., "Diamond nano-wires, a new approach towards next generation electrochemical gene sensor platforms", Diamond and Related Materials, Vol. 18, Issues 5-8, (2009), pages 910-917.
**[2]** V. Baranauskas and al., "Method of porous diamond deposition on porous silicon", Applied Surface Science, Vol. 185, Issues 1-2, 28 December 2001, pages 108-113.
**[3]** US 6,749,931 B1.
**[4]** T. Kondo and al., "Conductive diamond hollow fiber membranes", Electrochemistry Communications, Vol. 11, Issue 8, August 2009, pages 1688-1691.
**[5]** H.Sakaue and al., "Low dielectric constant porous diamond films formed by diamond nanoparticles", Appl. Phys. Lett., 83, (2003), page 2226.
**[6]** US 2005/0277303 A1.
**[7]** US 2009/0127136 A1.
**[8]** US 5,885,541.

## Revendications

1. Procédé de fabrication d'une couche en diamant ayant une structure tridimensionnelle poreuse, le procédé étant du type comprenant la croissance de la couche en diamant à partir d'un matériau sacrificiel et la décomposition progressive de ce matériau sacrificiel au cours de la croissance de la couche en diamant, ledit procédé comprenant les étapes suivantes :
1) la fourniture d'un substrat apte à supporter la croissance par dépôt chimique en phase vapeur assisté par plasma de la couche de diamant sur au moins une des faces du substrat, le substrat comportant sur ladite au moins une face une couche en un matériau sacrificiel ayant une structure tridimensionnelle poreuse et étant apte à se décomposer progressivement au contact de ce plasma, la couche en matériau sacrificiel contenant des grains de diamant de taille nanométrique ;
2) la croissance par dépôt chimique en phase vapeur assisté par plasma de la couche en diamant à partir des grains de diamant et la décomposition concomitante et progressive du matériau sacrificiel au contact de ce plasma.

2. Procédé de fabrication selon la revendication 1, dans lequel la croissance de la couche en diamant est stoppée lorsqu'à la fois la décomposition du matériau sacrificiel est complète et que la couche en matériau diamant a une porosité souhaitée.

3. Procédé de fabrication selon la revendication 1, dans lequel la décomposition du matériau sacrificiel comporte la gravure du matériau sacrificiel par le plasma.

4. Procédé de fabrication selon la revendication 1, dans lequel le matériau sacrificiel est un polymère.

5. Procédé de fabrication selon la revendication 4, dans lequel le matériau sacrificiel est un polypyrrole.

6. Procédé de fabrication selon la revendication 4, dans lequel le substrat et le matériau sacrificiel sont électriquement conducteurs et la couche en matériau sacrificiel présente sur au moins une face du substrat est déposée par électro-polymérisation.

7. Procédé de fabrication selon la revendication 1, dans lequel la taille des grains de diamant est inférieure ou égale à 100 nm, de préférence inférieure ou égale à 15 nm.

8. Procédé de fabrication selon la revendication 1, dans lequel la couche de diamant poreux a une porosité occupant de 5 à 50% du volume totale de la couche de diamant poreux.

## Patentansprüche

1. Herstellungsverfahren einer Diamantschicht, welche eine poröse dreidimensionale Struktur aufweist, wobei das Verfahren von der Art ist, dass das Wachstum der Diamantschicht aus einem Opfermaterial und die fortschreitende Zersetzung des Opfermaterials während des Wachstums der Diamantschicht erfolgen, wobei das Verfahren die folgenden Schritte umfasst:
1) Bereitstellen eines Substrats, welches geeignet ist, das Wachstum durch plasmaunterstützte chemische Gasphasenabscheidung der Diamantschicht auf mindestens einer Seite des Substrats zu ermöglichen, wobei das Substrat auf dieser mindestens einen Seite eine Schicht aus einem Opfermaterial enthält, welches eine poröse dreidimensionale Struktur aufweist, und geeignet ist, sich in Kontakt mit dem Plasma fortschreitend zu zersetzen, wobei die Schicht aus Opfermaterial eine Diamantkörnung in Nanometer-Größe enthält;
2) Wachsenlassen der Diamantschicht aus der Diamantkörnung durch plasmaunterstützte chemische Gasphasenabscheidung, und gleichzeitiges und fortschreitendes Zersetzen des Opfermaterials in Kontakt mit dem Plasma.

2. Herstellungsverfahren nach Anspruch 1, wobei das Wachstum der Diamantschicht angehalten wird, wenn sowohl die Zersetzung des Opfermaterials abgeschlossen ist, als auch die Schicht aus Diamantmaterial eine gewünschte Porosität aufweist.

3. Herstellungsverfahren nach Anspruch 1, wobei die Zersetzung des Opfermaterials das Ätzen des Opfermaterials durch das Plasma umfasst.

4. Herstellungsverfahren nach Anspruch 1, wobei das Opfermaterial ein Polymer ist.

5. Herstellungsverfahren nach Anspruch 4, wobei das Opfermaterial ein Polypyrrol ist.

6. Herstellungsverfahren nach Anspruch 4, wobei das Substrat und das Opfermaterial elektrische Leiter sind und die Opfermaterial-Schicht, welche auf mindestens einer Seite vorhanden ist, durch Elektropolymerisation aufgebracht wird.

7. Herstellungsverfahren nach Anspruch 1, wobei die Größe der Diamantkörnung weniger als oder gleich 100 nm, vorzugsweise weniger als oder gleich 15 nm ist.

8. Herstellungsverfahren nach Anspruch 1, wobei die poröse Diamantschicht eine Porosität von 5 bis 50% des gesamten Volumens der porösen Diamantschicht aufweist.

## Claims

1. Method for manufacturing a diamond layer having a porous three-dimensional structure, the method being of the type which includes growing the diamond layer from a sacrificial material and gradually decomposing said sacrificial material during growth of the diamond layer, said method including the following steps:
1) provision of a substrate capable of supporting the plasma-enhanced chemical vapour deposition growth of the diamond layer on at least one of the faces of the substrate, the substrate comprising on said at least one face a layer made of a sacrificial material having a porous three-dimensional structure and being able to decompose progressively upon contact with said plasma, the layer of sacrificial material containing diamond grains of nanometric size;
2) growth by plasma-enhanced chemical vapour deposition of the diamond layer from diamond grains and concomitant and gradual decomposition of the sacrificial material upon contact with said plasma.

2. Method for manufacturing according to claim 1, wherein the growth of the diamond layer is stopped when both the decomposition of the sacrificial material is complete and when the layer of diamond material has a desired porosity.

3. Method for manufacturing according to claim 1, wherein the decomposition of the sacrificial material comprises the etching of the sacrificial material by the plasma.

4. Method for manufacturing according to claim 1, wherein the sacrificial material is a polymer.

5. Method for manufacturing according to claim 4, wherein the sacrificial material is a polypyrrole.

6. Method for manufacturing according to claim 4, wherein the substrate and the sacrificial material are electrically conductive and the layer of sacrificial material present on at least one face of the substrate is deposited by electro-polymerisation.

7. Method for manufacturing according to claim 1, wherein the size of the diamond grains is less than or equal to 100 nm, preferably less than or equal to 15 nm.

8. Method for manufacturing according to claim 1, wherein the porous diamond layer has a porosity occupying from 5 to 50% of the total volume of the porous diamond layer.
